# EUROPEAN PATENT APPLICATION

(11) **EP 4 741 542 A1**
(43) Date of publication of application: **13.05.2026**
(21) Application number: 24835888.9
(22) Date of filing: 18.06.2024
(51) Int. Cl.: C30B 29/38, C30B 25/18, H01L 21/205

(54) **PRODUCTION METHOD FOR GAN EPITAXIAL FILM AND PRODUCTION METHOD FOR SEMICONDUCTOR DEVICE**

(30) Priority: 03.07.2023 JP 2023109212
(71) Applicant: Shin-Etsu Handotai Co., Ltd., Tokyo 100-0004 (JP)
(72) Inventor: HAGIMOTO Kazunori, Annaka-shi, Gunma 379-0196 (JP); YAMADA Masato, Tokyo 100-0004 (JP)
(74) Representative: Schicker, Silvia
(86) International application number: PCT/JP2024/021963
(87) International publication number: WO 2025/009374

(57) **Abstract**

The present invention is a method for producing a GaN epitaxial film, the method including the steps of providing a support substrate having a diameter of 150 mm or more and a thickness of less than 1 mm, in which the support substrate includes a core composed of nitride ceramic enclosed by an encapsulating layer, producing a substrate in which a planarization layer and a seed crystal layer composed of SiC single crystal are sequentially laminated on the support substrate to obtain a substrate for epitaxial growth, and epitaxially growing a GaN epitaxial film having a thickness of 7 µm or more on the substrate for epitaxial growth, by which the GaN epitaxial film having a dislocation density of 1.0×10⁶ / cm² or less is produced. This provides the method for producing a thick GaN film having a dislocation density of 1.0×10⁶ / cm² or less, in which the film has a large diameter without warping and cracking at low cost using a simple process.

## Description

### TECHNICAL FIELD

The present invention relates to a method for producing a GaN epitaxial film and a method for producing a semiconductor device.

### BACKGROUND ART

With regard to substrates on which GaN epitaxial films are formed, bulk substrates such as Si, GaAs, or Sap (sapphire) are promising due to the availability of large-diameter substrates at low cost. However, in an attempt to reduce dislocation density in the epitaxial films by increasing thickness, problems such as substrate warping or cracking may arise. Moreover, attempts to overcome these problems lead to significantly complex buffer steps, and this results in degraded productivity.

In contrast, GaN bulk substrate systems and those of AlN, having a close coefficient of thermal expansion as well as a similar lattice constant, are promising in terms of material properties. However, the substrates having a diameter of 150 mm or more have not yet been mass-produced and are therefore expensive. Although Patent Document 1 discloses a method in which a GaN film having low dislocation density is formed on a substrate of a different kind using a VAS (Void-Assisted Separation) method, and is used as a substrate, it remains unclear whether an increase in diameter is achievable, and the steps in the method are complex. In addition, although Non Patent Document 1 discloses an example in which a defect density on a GaN on Si substrate is high and is therefore improved with GaN on GaN, it is unclear whether a diameter enlargement is achievable.

As disclosed in Patent Documents 2 and 3, when substrates having ceramic cores are used, which have substantially the same coefficient of thermal expansion compared with that of crystals to be formed, thick films can be formed. However, a difference in lattice constants between seed crystals, such as Si, and the crystals to be formed makes it difficult to achieve a dislocation density of 1.0×10⁶ / cm² or less in the crystals.

Note that when a substrate having a ceramic core is used, Patent Document 4 discloses a method to separate a support substrate including a ceramic core by ion implantation, thereby producing a vertical transistor. Moreover, Patent Document 5 discloses another method to separate a support substrate including a ceramic core by etching a planarization layer (SiO₂ layer), thereby providing a device for ultraviolet light emission.

Further, Patent Documents 4 and 6 disclose that SiC, AlN, AlGaN, and Al₂O₃, in addition to Si, can be employed as a single crystal layer on a support substrate including a ceramic core, and the materials having lattice constants close to the ceramic core are preferable. However, no disclosure is provided on whether dislocation density can be lowered or not.

In addition, ELO (Epitaxial Lateral Overgrowth) is also known as a means to reduce dislocation density.
For example, Patent Documents 7 and 8 disclose ELO growth on support substrates of Patent Document 2, using island-shaped SiN. Moreover, Patent Documents 9 and 10 disclose a concept in which GaN is grown in a two-step island shape on a Si-containing film that includes island-shaped SiN to perform ELO growth, thereby reducing dislocation density. The disclosure includes that the Si (doping) concentration in the two-step island-shaped growth portion is 1.0×10¹⁷ to 10²⁰ / cm³.

Patent Document 11 discloses that island-shaped GaN is formed under growth conditions, and ELO is grown to reduce dislocation density without using masks, such as SiN. This document also discloses that a GaN film having a TD (threading dislocation) density of 5.0×10^{6 /} cm² can be obtained through one process, and the GaN film having 5.0×10^{5 /} cm² can be obtained through three processes.

However, these techniques are used to form ELO on Si, and the reduction of dislocation density is required to perform a plurality of ELOs.

As a method for reducing dislocation density, a method is known to prevent a growth of a plane (0001) prone to propagate dislocation from underneath intact, as a base layer, and instead to form a film composed of an inclined surface, resulting in a reduction of dislocation. Such a growth of the inclined surface film is realized either by using masks, such as island-shaped SiN (Patent Documents 1, 12, and 13), or by controlling growth conditions without pattern processing, such as mask layers (Patent Documents 14 to 17). Note that substrates used herein are freestanding GaN substrates produced once by a VAS method on substrates composed of Si, GaAs, Sap, or the like. However, it is unclear whether enlargement of a diameter can be achieved or not.

### CITATION LIST

### PATENT LITERATURE

Patent Document 1: JP 2020-070229 A
Patent Document 2: JP 2013-177285 A
Patent Document 3: JP 2019-523994 A
Patent Document 4: WO 2021/230148 A1
Patent Document 5: JP 2022-056492 A
Patent Document 6: JP 2022-012558 A
Patent Document 7: JP 2022-165964 A
Patent Document 8: JP 2020-505767 A
Patent Document 9: JP 2018-88528 A
Patent Document 10: JP 2015-29042 A
Patent Document 11: JP 2016-41654 A
Patent Document 12: JP 2020-070230 A
Patent Document 13: JP 2020-033210 A
Patent Document 14: JP 2020-033211 A
Patent Document 15: JP 2020-033212 A
Patent Document 16: JP 2020-033253 A
Patent Document 17: JP 2020-033254 A

### NON PATENT LITERATURE

Non Patent Document 1: Odyssey Semiconductor, Inc. "Defects Matter", Odyssey Semiconductor, Inc., 2023, [Accessed May 17, 2023], Internet <URL: https://odysseysemi.com/technology/>

### SUMMARY OF INVENTION

### TECHNICAL PROBLEM

Accordingly, various techniques have been proposed to increase a film thickness of an epitaxial layer, enlarge a diameter, and reduce dislocation density. The low-cost, simple production method of a GaN epitaxial film has not been found, which is also capable of enlarging a diameter, preventing occurrence of warp or crack during film-thickening, and reducing dislocation density.

The present invention has been made in view of the above-described problem. An object of the present invention is to provide a method for producing a GaN epitaxial film, which produces a thick GaN film having a large diameter, no warping or cracking, and a dislocation density of 1.0×10⁶ / cm² or less at low cost using a simple process.

Moreover, an object of the present invention is to provide a method for producing a semiconductor device, which can produce a high-quality semiconductor device at low cost.

### SOLUTION TO PROBLEM

To achieve the object, the present invention provides a method for producing a GaN epitaxial film, the method comprising the steps of:
providing a support substrate having a diameter of 150 mm or more and a thickness of less than 1 mm, in which the support substrate comprises a core composed of nitride ceramic enclosed by an encapsulating layer;
producing a substrate in which a planarization layer and a seed crystal layer composed of SiC single crystal are sequentially laminated on the support substrate to obtain a substrate for epitaxial growth; and
epitaxially growing a GaN epitaxial film having a thickness of 7 µm or more on the substrate for epitaxial growth,
by which the GaN epitaxial film having a dislocation density of 1.0×10⁶ / cm² or less is produced.

According to such a method for producing a GaN epitaxial film, by growing the GaN epitaxial film on the substrate for epitaxial growth, including a ceramic core, it is possible to produce a thick GaN film, unlike bulk substrates, such as Si, Sap, and GaAs. These bulk substrates are unable to form a thick GaN epitaxial film, due to difference in coefficient of thermal expansion therebetween, even though less expensive and large diameter products are present. Furthermore, when such a low-dislocation thick film can be produced, crystallinity in a device layer is favorable, and thus withstand voltage is enhanced and leakage current is reduced in an electronic device. Additionally, in visible and ultraviolet light devices, higher output or greater efficiency can be promoted, and this contributes to energy savings.

Moreover, according to such a method for producing a GaN epitaxial film, a single crystal layer on the support substrate is composed of a SiC single crystal. Moreover, SiC is a material having a lattice constant closer to GaN than Si, and is inexpensive and available in a large diameter compared with other crystal layers capable of producing high-quality GaN epitaxial films, such as GaN or AlN. Consequently, an epitaxial GaN film having no warping or cracking and a dislocation density of 1.0×10⁶ / cm² or less can be formed through a simple process.

Furthermore, by setting the diameter of the support substrate to 150 mm or more, a large-diameter GaN epitaxial film can be formed.

In addition, by growing the GaN epitaxial film by 7 µm or more, it is possible to achieve an epitaxial film thickness that is unable to be formed by bulk substrates composed of Si, Sap, or GaAs, because such bulk substrates are unable to form thick GaN epitaxial films due to differences in coefficients of thermal expansion, while inexpensive and large-diameter products are available.

Further, by setting the thickness of the support substrate to less than 1 mm, it is possible to process such a support substrate through a conventional CMOS production line for a silicon epitaxial wafer. For example, in a GaN on Si substrate device, a Si substrate having a thickness of conventional standards is unusable due to warping and cracking caused by the difference in the coefficient of thermal expansion. Thus, a thick substrate having a thickness of 1 mm or more, produced by bonding or other means, is required, and is therefore unable to process through the conventional CMOS production line for silicon; however, the processing through the CMOS production line is enabled in the present invention.

Consequently, a thick GaN film having a dislocation density of 1.0×10⁶ / cm² or less can be produced at low cost using a simple process, while achieving a large diameter without warping and cracking.

In this case, in the step of epitaxially growing,
a forming step for forming a SiN layer in an island shape and an ELO step for growing a GaN layer using the SiN layer as a mask may be performed, and a growth step may be subsequently performed to grow the GaN epitaxial film on the uppermost SiN layer or the uppermost GaN layer.

This enables a further reduction in the dislocation density of the GaN epitaxial film.

In this case, in the step of epitaxially growing,
the forming step and the ELO step may be alternately performed.

This enables further reduction in the dislocation density of the GaN epitaxial layer compared with performing each of the forming step and the ELO step only once.

In this case, the SiC single crystal may have an off-angle of 0° to 4°.

This enables the growth of a group III nitride epitaxial film in step-flow mode.

Moreover, the present invention provides a method for producing a semiconductor device, the method comprising:
forming a device on the GaN epitaxial film produced by the method for producing a GaN epitaxial film described above; and
subsequently, etching the planarization layer to separate the device from the support substrate.

According to such a method for producing a semiconductor device, the device is formed on the epitaxial film in which the thick GaN film is produced with a large diameter, a dislocation density of 1.0×10⁶ / cm² or less, without warping or cracking, at low cost using a simple process. As a result, the high-quality semiconductor device without warping or cracking can be produced at low cost.

Furthermore, by etching the planarization layer between the support substrate and the epitaxial film to separate the support substrate portion having an insulating property, only the conductive GaN film can be used for the semiconductor device. Even when the support substrate portion having an insulating property is present, in a vertical device that requires current flow in the vertical direction, backside electrical contact to the substrate can provide a simplified step of forming a device.

### ADVANTAGEOUS EFFECTS OF INVENTION

As described above, according to the inventive method for producing a GaN epitaxial film, the thick GaN film can be produced with a large diameter, a dislocation density of 1.0×10⁶ / cm² or less, without warping or cracking, at low cost using a simple process.

In addition, according to the inventive method for producing a semiconductor device, a high-quality semiconductor device can be produced at low cost.

### BRIEF DESCRIPTION OF DRAWINGS

[FIG. 1] illustrates an epitaxial substrate on which a GaN epitaxial film obtained by a method for producing a GaN epitaxial film according to an embodiment of the present invention is formed.
[FIG. 2] shows an example of a method for producing a GaN epitaxial film, and a method for producing a semiconductor device in which the produced epitaxial film is employed.
[FIG. 3] illustrates a device employing a GaN epitaxial film according to the present invention.
[FIG. 4] illustrates a device employing a GaN epitaxial film according to the present invention.
[FIG. 5] illustrates an epitaxial film in Example 1.
[FIG. 6] illustrates a production procedure of an epitaxial film and a semiconductor device in Example 2.
[FIG. 7] illustrates a production procedure of an epitaxial film and a semiconductor device in Example 2.
[FIG. 8] illustrates a production procedure of an epitaxial film and a semiconductor device in Example 3.
[FIG. 9] shows a cross-sectional photograph of an epitaxial film in Example 3.
[FIG. 10] illustrates a production procedure of an epitaxial film and a semiconductor device in Example 4.
[FIG. 11] illustrates a production procedure of an epitaxial film and a semiconductor device in Example 5.
[FIG. 12] illustrates a production procedure of an epitaxial film and a semiconductor device in Example 6.
[FIG. 13] illustrates a production procedure of an epitaxial film and a semiconductor device in Comparative Example 1.

### DESCRIPTION OF EMBODIMENTS

Hereinafter, the present invention will be described in detail. However, the present invention is not limited thereto.

As described above, a method for producing a GaN epitaxial film has been desired, in which the method produces a thick GaN film at low cost using a simple process, while achieving a large diameter without warping and cracking, and a dislocation density of 1.0×10⁶ / cm² or less.

To solve the above problem, the present inventors have earnestly studied and found a method for producing a GaN epitaxial film, the method including the steps of: providing a support substrate having a diameter of 150 mm or more and a thickness of less than 1 mm, in which the support substrate includes a core composed of nitride ceramic enclosed by an encapsulating layer; producing a substrate in which a planarization layer and a seed crystal layer composed of SiC single crystal are sequentially laminated on the support substrate to obtain a substrate for epitaxial growth; and epitaxially growing a GaN epitaxial film having a thickness of 7 µm or more on the substrate for epitaxial growth, by which the GaN epitaxial film having a dislocation density of 1.0×10⁶ / cm² or less is produced. Through this method, the present inventors found that this method can produce a thick GaN film at low cost using a simple process, while achieving a large diameter without warping and cracking, and a dislocation density of 1.0×10⁶ / cm² or less. This finding has led to the completion of the present invention.

As described above, a method for producing a semiconductor device that can produce a high-quality semiconductor device at low cost has been desired.

To solve the above problem, the present inventors have earnestly studied and found a method for producing a semiconductor device, the method including: forming a device on the GaN epitaxial film produced by the method for producing a GaN epitaxial film described above; and subsequently, etching the planarization layer to separate the device from the support substrate. Through this method, the present inventors found that this method can produce a high-quality semiconductor device at low cost. This finding has led to the completion of the present invention.

Hereinafter, the following description will be made with reference to the drawings.

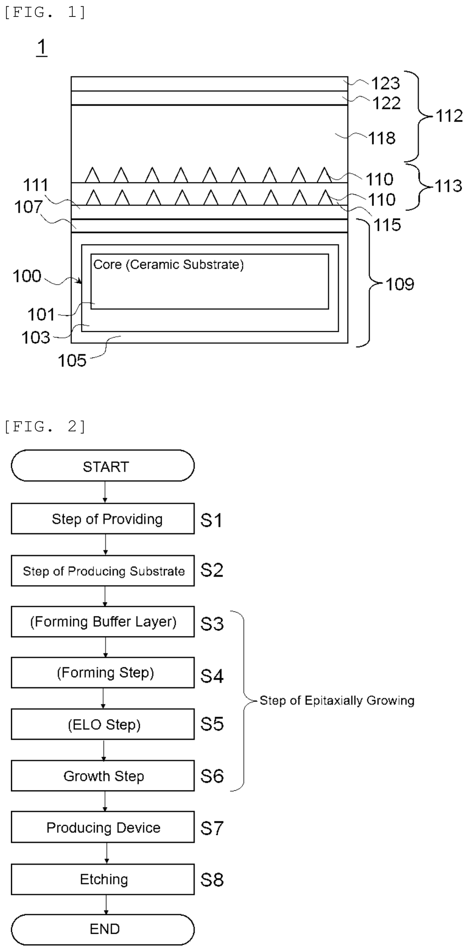

Hereinafter, a method for producing a GaN epitaxial film according to the embodiment of the present invention will be described with reference to FIGs. 1 and 2.

First, the GaN epitaxial film that can be obtained by the method for producing a GaN epitaxial film according to the embodiment of the present invention will be described with reference to FIG. 1. Here, as the GaN epitaxial film, a film for a vertical power device (MOS-FET) is exemplified.

As shown in FIG. 1, a GaN epitaxial film 112 is formed on a substrate for epitaxial growth 109. The substrate for epitaxial growth 109 serves both as a base on which the GaN epitaxial film 112 is grown and as a supporting member for preventing deformation of the GaN epitaxial film 112, such as warping. Note that, as shown in FIG. 1, a laminate in which the GaN epitaxial film 112 is formed on the substrate for epitaxial growth 109 is referred to as an epitaxial substrate 1 in the following description.

The substrate for epitaxial growth 109 is provided with a support substrate 100, a planarization layer 105, and a seed crystal layer 107. In FIG. 1,
a buffer layer 111 is formed on the substrate for epitaxial growth 109, and an ELO layer 113 is further formed on the buffer layer 111.

The support substrate 100 is a supporting member to prevent the deformation of the GaN epitaxial film 112, and is provided with a core 101 and an encapsulating layer 103.

The core 101 is a layer that serves as a foundation of the support substrate 100, and is composed of, for example, nitride ceramic, such as AlN. The encapsulating layer 103 is a layer that covers around (or both surfaces of) the core 101 to prevent diffusion of impurities. For example, this layer is composed of SiO₂, SiN, a mixed composition thereof, and preferably SiN. The coating has a thickness of, for example, approximately 200 nm.

The planarization layer 105 is a layer to planarize unevenness attributed to an outer shape of the core 101 or the encapsulating layer 103. In addition, the planarization layer 105 is also a portion removed by etching when the device is formed on the GaN epitaxial film 112, and is then separated from the substrate for epitaxial growth 109. The planarization layer 105 includes, for example, any of silicon oxide, silicon oxynitride, and aluminum arsenide, and more specifically, silicon oxide (SiO₂). The planarization layer 105 is provided at least on a side where the seed crystal layer 107 is bonded, and may alternatively be provided so as to cover the entire substrate or both surfaces of the substrate.

The seed crystal layer 107 is a layer that serves as a foundation on which the GaN epitaxial film 112 is grown, and is composed of a SiC single crystal. SiC is a material having a lattice constant closer to that of GaN than Si, and SiC is available in large diameter at low cost compared with other crystalline layers, such as GaN and AlN, which can be used to produce a high-quality GaN epitaxial film. Consequently, the GaN epitaxial film having the dislocation density of 1.0×10⁶ / cm² or less without warping and cracking can be formed using a simple process. Note that the lower limit of the dislocation density is not particularly limited, but can be, for example, 1.0×10⁴ / cm² or more.

Note that a crystal structure of the SiC single crystal is not particularly limited, and examples include 6H-SiC, 4H-SiC, and 3C-SiC. For example, 4H-SiC can be suitably used for an electronic device, and 6H-SiC and 4H-SiC can be suitably used for a visible light device and an ultraviolet light device.

The buffer layer 111 is a layer provided as needed to mitigate a mismatch due to a difference in lattice constants between the seed crystal layer 107 and the GaN epitaxial film 112, or stress to the GaN epitaxial film 112. For example, AlN, AlGaN, or the like is used.

The ELO layer 113 is a layer to reduce the dislocation density during epitaxially growing the GaN epitaxial film 112, and is formed as needed when further reducing the dislocation density.

The ELO layer 113 is provided with a SiN layer 110 and a GaN layer 115.

The SiN layer 110 is an island-shaped layer that serves as a mask when the GaN layer 115 is grown. The GaN layer 115 is a layer of GaN grown from a gap where the mask formed by the SiN layer 110 is absent, and a layer to reduce the dislocations that reach the GaN epitaxial film 112 by controlling the growth direction of the GaN layer 115 during the growth thereof by the SiN layer 110 and then by deflecting the dislocation direction. The density or size of the island-shaped SiN layer 110 can be adjusted as appropriate, depending on a device application. Note that FIG. 1 conceptually and schematically illustrates features of the SiN layer 110; however, the SiN layer 110 is illustrated in a layered shape in the following drawings for convenience.

Here, the GaN epitaxial film 112 is a single-crystal layer where the semiconductor device is formed. A composition of the GaN epitaxial film 112 is not limited to GaN, and includes other group III nitrides, such as InN and AlN, and a mixed crystal thereof. The composition, structure, and conductivity type of the GaN epitaxial film 112 may be selected as appropriate according to the device to be formed, and the film may be multilayered. FIG. 1 exemplifies a laminated structure formed with an n-GaN layer 118, a p-GaN layer 122, and a GaN layer 123. Here, the GaN epitaxial film is required to have a thickness of 7 µm or more. Note that the upper limit of the thickness of the GaN epitaxial film is not particularly limited, but can be, for example, 50 µm or less.

The foregoing is the description of the GaN epitaxial film 112.

Next, an example of a method for producing a GaN epitaxial film 112 and an example of a method for producing a semiconductor device, in which the produced GaN epitaxial film 112 is used, will be described with reference to FIG. 2.

The support substrate 100 shown in FIG. 1, having a diameter of 150 mm or more and a thickness of less than 1 mm, is provided. This substrate includes the core 101 composed of nitride ceramic and encapsulated by the encapsulating layer 103 (S1 in FIG. 2: Step of Providing).

Here, the support substrate is required to have a diameter of 150 mm or more. When the diameter is less than 150 mm, this leads to the diameter of the GaN epitaxial film 112 being less than 150 mm. As a result, enlargement of the diameter is prevented. Note that the upper limit of the diameter of the support substrate is not particularly limited, but can be, for example, 500 mm or less.

Moreover, the support substrate is required to have a thickness of less than 1 mm. When the thickness is 1 mm or more, the thickness of the epitaxial substrate 1 becomes 1 mm or more. Consequently, even when the GaN epitaxial film 112 is attempted to be introduced into conventional CMOS lines designed for silicon to form the device to the film 112, the substrate is too thick to process through a line. Note that the lower limit of the support substrate is not particularly limited, but can be, for example, 0.1 mm or more.

More preferably, the support substrate 100 has a thickness that falls within the thickness standards for the Si substrates defined by JEITA or SEMI. This ensures processing through the conventional CMOS line for silicon.

Next, the substrate for epitaxial growth 109 is obtained by sequentially laminating the planarization layer 105 and the seed crystal layer 107 composed of SiC single crystal on the support substrate 100 shown in FIG. 1 (S2 in FIG. 2: Step of Producing Substrate).

A specific method for forming the planarization layer 105 may include: forming an oxide film such as SiO₂ on the surface of the support substrate 100 using a plasma CVD method, an LPCVD method, or a low-pressure MOCVD method, or the like; subjecting to thermal stabilization treatment; and smoothing the surface by polishing using a known polishing method such as CMP. The planarization layer 105, after polishing, has a thickness of 0.05 µm or more and 3.0 µm or less, for example.

As a method for forming the seed crystal layer 107, a method for transferring a surface layer of a SiC single crystal substrate can be exemplified. Specifically, hydrogen ions are first implanted from a C-plane side of the SiC single crystal substrate produced using a sublimation method, and a split interface is formed in advance. Next, the C-plane side of the hydrogen-ion-implanted SiC single crystal substrate is bonded to the planarization layer 105. At this time, surface activation treatment can be performed as needed to eliminate voids.

Next, a split heat treatment is performed in a state where the SiC single crystal substrate is bonded to the planarization layer 105; accordingly, separation occurs starting from a hydrogen ion-implanted layer, and the surface layer of the SiC single crystal substrate is transferred onto the planarization layer 105. As the split interface is exposed as the surface, surface polishing such as CMP, wet etching, or dry etching is performed to remove a damage layer generated by the separation.

Note that the SiC single crystal constituting the seed crystal layer 107, having an off-angle of 0° to 4°, is preferably used. This enables the growth of a group III nitride epitaxial film formed on the seed crystal layer 107 in step-flow mode. When a low off-angle is needed, depending on the circumstance, a substrate having an off-angle of 0° may be cut out from a substrate having an off-angle of 4° and may be used.

The seed crystal layer 107 has a thickness of, for example, 0.04 µm or more and 1.0 µm or less, but is set as appropriate depending on the structure or type of the device formed onto the GaN epitaxial film 112.

Moreover, conductivity of the seed crystal layer 107 can be selected as either conductive or nonconductive, depending on the structure or type of the device formed onto the GaN epitaxial film 112. For example, low resistivity (approximately 20 mΩcm) or high resistivity (1.0×10⁶ Ωcm or more) can be exemplified.

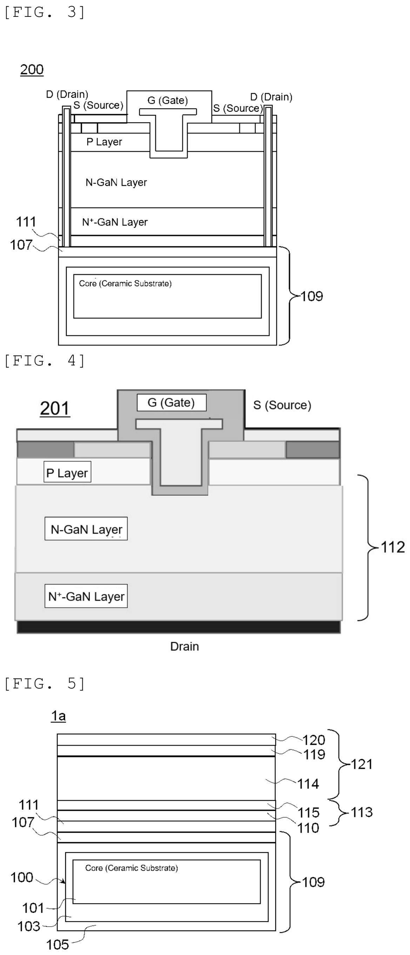

For example, in a device that requires applying current vertically through a device layer portion, electrode-formed positions may have either a method in which all electrodes are formed on the same surface side, as shown in FIG. 3, or a method in which electrodes are respectively formed on the upper and lower surfaces, as shown in FIG. 4.

Herein, the device layer portion is a term that collectively denotes portions above the seed crystal layer 107, namely the GaN epitaxial film 112, or a laminate including the buffer layer 111, the ELO layer 113, and the GaN epitaxial film 112.

A device 200 (MOS-FET), shown in FIG. 3, shows a case of the device application in which the seed crystal layer 107 is conductive, and the substrate for epitaxial growth 109 remains. In this case, the seed crystal layer 107 is used for forming a drain electrode; consequently, it is preferable that the seed crystal layer 107 has a thicker thickness to reduce lateral resistance. For example, a thickness of 300 nm or more is suitable. In addition, in order to facilitate the formation of ohmic contact, it is preferable to reduce the resistivity of the seed crystal layer 107 to approximately 0.01 to 0.03 Ωcm.

On the other hand, a device 201 (MOS-FET) shown in FIG. 4 shows a case of the device application in which the seed crystal layer 107 has high resistivity, semi-insulating, or insulating; and after forming the device onto the GaN epitaxial film 112, only the device layer portion is separated. In this case, the seed crystal layer 107 is preferably thinner for removal; for example, a thickness of less than 300 nm is suitable. Note that when the seed crystal layer 107 is conductive, the removal of the seed crystal layer 107 is not required. Consequently, the device can be used as an electrode forming type shown in FIG. 4 in a state where the seed crystal layer 107 remains beneath the device layer portion.

When current flows into the lower portion is undesirable for a device, such as an RF device, the semi-insulating seed crystal layer 107 is desirable.

Next, the buffer layer 111 is formed on the seed crystal layer 107 as needed (S3 in FIG. 2). A MOCVD method can be exemplified as a method for forming a buffer layer 111.

Next, the ELO layer 113 is formed as needed.

Specifically, a forming step for forming the SiN layer 110 in the island shape (S4 in FIG. 2) and an ELO step for growing the GaN layer 115 using the SiN layer 110 as a mask are performed (S5 in FIG. 2).

Accordingly, the dislocation density of the GaN epitaxial film can be further reduced.

Note that the forming step and the ELO step may be alternately performed as needed to form a plurality of the SiN layers 110 and the GaN layers 115. This enables further reduction of dislocation density in the GaN epitaxial film 112 compared with a case where the forming step and the ELO step are each performed once.

Subsequently, the GaN epitaxial film 112 is grown (S6 in FIG. 2: Growth Step).

When the forming step and the ELO step are performed, the GaN epitaxial film 112 is formed on the topmost SiN layer 110 or the topmost GaN layer 115. When the forming step and the ELO step are not performed and the buffer layer 111 is formed, the GaN epitaxial film 112 is formed on the buffer layer 111. When the forming step and the ELO step are not performed and the buffer layer 111 is not also formed, the GaN epitaxial film 112 is formed on the seed crystal layer 107.

Note that it is preferable that a surface of the seed crystal layer 107 that is epitaxially grown is a Si-plane where the epitaxial layer tends to form a flat surface, but a C-plane may also be used. Moreover, S3 through S6 may be collectively referred to as an epitaxial step.

The foregoing is the description of the method for producing a GaN epitaxial film 112.

Next, the method for producing a semiconductor device using the GaN epitaxial film 112 produced by the method for producing a GaN epitaxial film 112 will be described.

First, a desired device is produced onto the GaN epitaxial film 112 (S7 in FIG. 2). The device production includes conversion of conductivity-type by ion-implantation, or the like, and formation of the electrode or insulation layer by sputtering, or the like.

Here, as shown in the device 200 in FIG. 3, even after forming the device onto the GaN epitaxial film 112, when the seed crystal layer 107 or the support substrate 100 is not separated from the GaN epitaxial film 112, the device is completed upon the above steps.

On the other hand, as shown in the device 201 in FIG. 4, when the support substrate 100 is separated from the GaN epitaxial film 112 after forming the device onto the GaN epitaxial film 112, the device is separated from the support substrate 100 by etching the planarization layer 105 (S8 in FIG. 2). Etchant is not particularly limited as long as the planarization layer 105 is dissolved; when the planarization layer 105 is composed of SiO₂, HF (hydrogen fluoride) solution can be exemplified.

Note that when separating, not only the planarization layer 105 but also the seed crystal layer 107 or the buffer layer 111 may be removed.

The foregoing is the description of the method for producing a semiconductor device.

Moreover, the semiconductor device to be produced is not particularly limited, but LED, LD (laser diode), PD (photodiode), HEMT (high electron mobility transistor), FET, HBT, and others are exemplified.

### EXAMPLES

Hereinafter, the present invention will be specifically described with reference to Examples. However, the present invention is not limited thereto.

### Example 1: Epitaxial Substrate for Vertical Device

First, according to the following procedures, a GaN epitaxial film 112 was grown to produce an epitaxial substrate 1a shown in FIG. 5.

To begin with, as shown in FIG. 1, a structure was produced, in which a nitride ceramic substrate (AlN) serving as a core 101 was covered by an encapsulating layer 103, and silicon oxide having a thickness of 0.05 µm to 3.0 µm was provided as a planarization layer 105 on at least a side to be bonded to a seed crystal layer 107.

Next, 4H-SiC (a resistivity of 20 Ωcm, a thickness of 0.04 µm to 1.0 µm, and an epitaxial growth surface serving as a Si-plane with an off-angle of 0°) was transferred, as the seed crystal layer 107, onto the planarization layer 105. Subsequently, a substrate for epitaxial growth 109 was placed into a growth apparatus and heated to a growth temperature (1000 to 1200°C). Then, TMA (trimethylaluminum), TMG (trimethylgallium), and NH₃ gas were supplied to form an Al_{0.2}Ga_{0.8}N layer by 0.15 µm, as a buffer layer 111, on the seed crystal layer 107. The Al_{0.2}Ga_{0.8}N layer was doped with Si as an n-type dopant at 1.0×10¹⁹ atoms/cm³.

Further, the supply of TMA and TMG was interrupted, and SiH₄ and NH₃ were then supplied to grow a SiN layer 110 having a thickness of 1 nm in an island shape on the buffer layer 111. Subsequently, the supply of SiH₄ was stopped, and TMG was introduced to epitaxially grow a GaN layer 115 to a thickness of 3.0 µm. Then, a Si-doped n-GaN layer 114 was epitaxially grown to a thickness of 7 µm, followed by the formation of an Mg-doped p-GaN layer 119 to a thickness of 0.5 µm, and a GaN layer 120 to a thickness of 0.5 µm on top of the Mg-doped p-GaN layer 119. Note that, as is well known, Mg doped in the GaN layer often stays inactive state immediately after epitaxially growing, in such a case, separate heat treatment is required to activate Mg as a p-type dopant. In this Example, heat treatment was performed at 1300°C in a nitrogen atmosphere under atmospheric pressure. Also, in the subsequent Examples, when the Mg-doped p-GaN layer is described, it is to be understood that the same treatment was performed. Through the above steps, an epitaxial substrate 1a was produced.

Next, dislocation density near a surface of the epitaxial substrate 1a was evaluated using SU-70 Photo Diode type Backscattered Electron Detector (PDBSE) manufactured by Hitachi High-Tech Corporation with an acceleration voltage of 5 kV within an area of 20 µm × 20 µm. As a result, the dislocation density was 7.5×10⁵ cm⁻², and the epitaxial substrate 1a for a vertical device, on which a high-quality GaN epitaxial film was grown, was successfully produced. Note that, in a group III nitride epitaxial growth layer, dislocation is annihilated as the layer grows. Consequently, even when the dislocation density exceeds 1.0×10⁶ / cm² in a lower layer portion at initial growth (in this Example, the GaN layer 115 or a bottom of the n-GaN layer 114), the dislocation density at an upper portion decreases sharply. Accordingly, according to the epitaxial substrate of the present invention, on which the GaN epitaxial film having a thickness of 7 µm or more was grown, the quality required for device performance was ensured by evaluating the portion near the surface of the produced epitaxial substrate.

### Example 2: MOS-FET

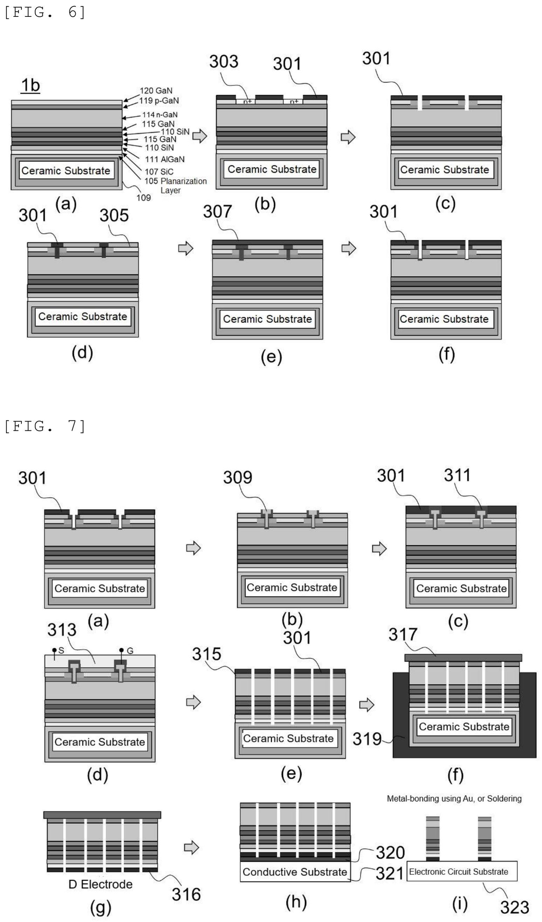

First, by following the procedures, a GaN epitaxial film 112 was grown to produce an epitaxial substrate 1b shown in FIG. 6 (a).

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, 4H-SiC (a resistivity of 20 Ωcm, a thickness of 0.04 µm to 1.0 µm, and an epitaxial growth surface serving as a Si-plane with an off-angle of 0°) was transferred as the seed crystal layer 107 onto the planarization layer 105. Then, as in Example 1, an Al_{0.2}Ga_{0.8}N layer of 0.15 µm was formed as a buffer layer 111 on the seed crystal layer 107. The Al_{0.2}Ga_{0.8}N layer was doped with Si at 1.0×10¹⁹ atoms/cm³.

Next, as in Example 1, a SiN layer 110 was grown in an island shape to a thickness of 1 nm on the buffer layer 111. Then, a GaN layer 115 was epitaxially grown by 2.0 µm; on the GaN layer 115, the SiN layer 110 was grown in an island shape by 1 nm, and the GaN layer 115 was further epitaxially grown by 1.0 µm on top of the SiN layer 110.

That is, when compared with the first embodiment, the number of laminated ELO layers 113 increased.

Subsequently, a Si-doped n-GaN layer 114 was epitaxially grown by 7 µm, followed by the formation of an Mg-doped p-GaN layer 119 by 0.5 µm, and a GaN layer 120 by 0.5 µm on top of the Mg-doped p-GaN layer 119. Through the above steps, an epitaxial substrate 1b was produced.

When dislocation density near a surface of the epitaxial substrate 1b was measured as in Example 1, the measured density was 6.0×10⁵ cm⁻². Consequently, the epitaxial substrate 1b for a vertical device, in which a high-quality GaN epitaxial film was grown, was successfully produced.

Next, this epitaxial substrate 1b for a vertical device was processed through device processes below to produce a vertical power device (MOS-FET). To begin with, as shown in FIG. 6 (b), a mask 301 having a predetermined pattern shape was formed by photolithography on an outermost surface of the epitaxial substrate 1b, and an n⁺ layer 303 was implanted by ion implantation through an opening of the mask 301, and the n⁺ layer 303 was thereby formed in the outermost GaN layer 120.

Further, as shown in FIG. 6 (c), the mask 301 having an opening that had been formed was formed by photolithography such that the n⁺ layer 303 was centered in the opening, and dry etching was performed down to the n-GaN layer 114.

Next, as shown in FIG. 6 (d), the mask 301 was formed by photolithography on the portion subjected to dry etching, and a SiN film 305 was then formed by sputtering. Thereafter, the mask 301 was removed, and a SiO₂ film 307 was formed by sputtering, as shown in FIG. 6 (e).

Next, as shown in FIG. 6 (f), after forming the mask 301 by photolithography, a center of the SiO₂ film 307 was etched by dry etching. Subsequently, the mask 301 was removed, and the mask 301 for a gate electrode was formed by photolithography, as shown in FIG. 7 (a).

Further, as shown in FIG. 7 (b), a gate electrode 309 was sputtered, and the mask 301 was then removed. Next, as shown in FIG. 7 (c), the mask 301 was formed by photolithography, and a SiO₂ film 311 was formed by sputtering for insulating the gate electrode 309. Further, as shown in FIG. 7 (d), after removing the mask 301, a source electrode 313 was sputtered.

Next, as shown in FIG. 7 (e), after forming the mask 301 for device isolation by photolithography, dry etching was performed down to a SiO₂ layer serving as the planarization layer 105. Note that, in FIG. 7 (e), the layers above the seed crystal layer 107 were collectively illustrated as a device layer portion 315 for simplifying the drawing.

Subsequently, as shown in FIG. 7 (f), the mask 301 was removed, and a temporary support substrate 317 was bonded to a device layer portion 315, and immersed in an HF solution 319. Accordingly, the SiO₂ layer serving as the planarization layer 105 was dissolved, thereby separating the device layer portion 315 from a portion below the planarization layer 105.

Thereafter, as shown in FIG. 7 (g), a drain electrode 316 was formed by sputtering on the seed crystal layer 107 of the device layer portion 315 side, and was then subjected to RTA (Rapid Thermal Anneal) treatment in a nitrogen atmosphere to form an ohmic electrode. Then Au 320 was sputtered thereon. In the following Examples, when heat treatment is required to form the ohmic contact of the electrode, the treatment is performed under generally known conditions, and the description thereof is omitted. Furthermore, as shown in FIG. 7 (h), the electrode 316 was metal-bonded to a substrate on which Au 320 was coated on a surface of a pre-prepared conductive substrate 321 by sputtering. Moreover, as shown in FIG. 7 (i), each of the isolated chips on the device layer portion 315 side was picked up, and bonded by soldering onto a substrate 323 where an electronic circuit had been formed thereon. As a result, the vertical power device (MOS-FET) serving as a semiconductor device was successfully formed.

### Example 3: SBD (Schottky Barrier Diode)

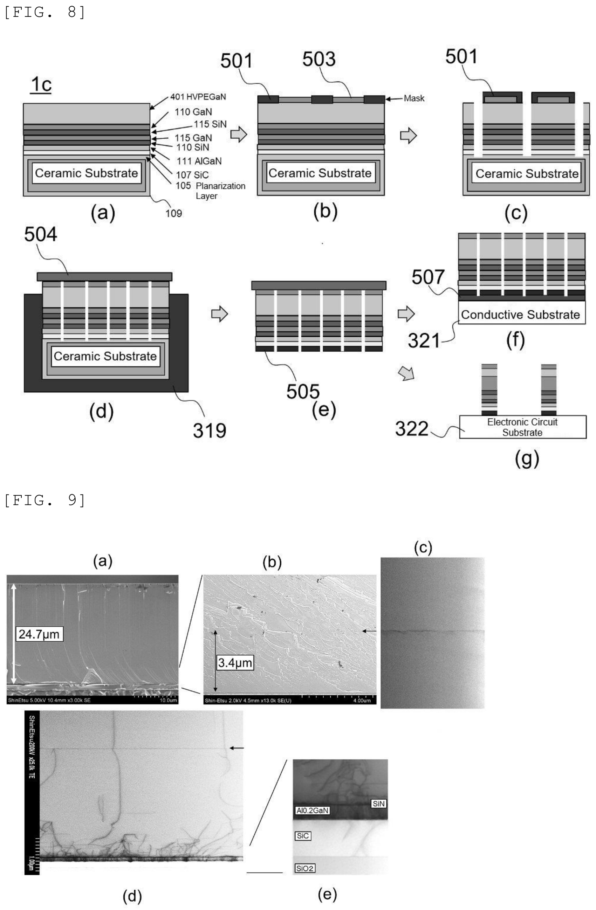

First, an HVPE-GaN epitaxial film 401 was grown as a GaN epitaxial film 112 by the following procedure to produce an epitaxial substrate 1c as shown in FIG. 8 (a).

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, 4H-SiC (a resistivity of 20 Ωcm, a thickness of 0.04 µm to 1.0 µm, and an epitaxial growth surface serving as a Si-plane with an off-angle of 0°) was transferred as the seed crystal layer 107 onto the planarization layer 105. Then, as in Example 1, an Al_{0.2}Ga_{0.8}N layer of 0.15 µm was formed as a buffer layer 111 on the seed crystal layer 107. The Al_{0.2}Ga_{0.8}N layer was doped with Si at 1.0×10¹⁹ atoms/cm³.

Next, as in Example 1, a SiN layer 110 was grown in an island shape to a thickness of 1 nm on the buffer layer 111, and a GaN layer 115 was then epitaxially grown by 3.4 µm. Subsequently, the SiN layer 110 was grown in an island shape to a thickness of 1 nm, and the GaN layer 115 was further epitaxially grown by 2.1 µm.

Subsequently, an HVPE-GaN epitaxial film 401 was further epitaxially grown by 19 µm using HVPE (Hydride Vapor Phase Epitaxy). Through the above steps, the epitaxial substrate 1c was produced.

As in Example 1, when dislocation density near a surface of the HVPE-GaN epitaxial film 401 was measured, the measurement result was 3.0×10⁵ cm⁻². Consequently, the epitaxial substrate 1c for a vertical device on which a high-quality GaN epitaxial film was grown was produced.

Moreover, when a cross-sectional surface of the epitaxial substrate 1c for a vertical device was observed using an electron microscope, as shown in FIG. 9, growth of the planarization layer 105 (SiO₂), the seed crystal layer 107 (SiC), the buffer layer 111, the SiN layer 110, and the HVPE-GaN epitaxial film 401 was identified.

Specifically, in a SEM image shown in FIG. 9 (a), a layer having a thickness of approximately 24.7 µm was observed. This thickness was approximately equal to the total thickness of the buffer layer 111 (thickness of 0.15 µm), the GaN layer 115 (thickness of 3.4 µm+2.1 µm), and the HVPE-GaN epitaxial film 401 (19 µm), indicating that the total thickness of these layers was a thickness as intended.

Moreover, as shown in FIGs. 9 (b) and (c), when the layer having a thickness of approximately 24.7 µm was magnified, a layer having a thickness of 3.4 µm was observed. This thickness was identical to that of a first layer of the GaN layer 115; consequently, it was found that the GaN layer 115 also had an intended thickness.

Furthermore, in TEM images shown in FIGs. 9 (d) and (e), it was identified that the planarization layer 105 (SiO₂), the seed crystal layer 107 (SiC), the buffer layer 111 (Al_{0.2}Ga_{0.8}N), and the SiN layer 110 were sequentially laminated.

Next, this epitaxial substrate 1c for a vertical device was processed through the device processes below to produce a vertical power device (SBD).

To begin with, as shown in FIG. 8 (b), a mask 501 for a Schottky electrode was formed by photolithography to form a Schottky electrode 503 by sputtering.

Subsequently, as shown in FIG. 8 (c), after forming the mask 501 by photolithography, dry etching was performed down to a SiO₂ layer serving as the planarization layer 105. Next, as shown in FIG. 8 (d), a temporary support substrate 504 was bonded to the Schottky electrode 503 side, and this structure was immersed in an HF solution 319 to dissolve SiO₂ serving as the planarization layer 105, thereby separating an upper portion (device layer portion) above the planarization layer 105 from a lower portion below the layer 105 to expose SiC serving as the seed crystal layer 107 toward a device layer portion side.

Furthermore, as shown in FIG. 8 (e), a drain electrode 505 was formed on a surface of the seed crystal layer 107, and Au 507 was further formed thereon as shown in FIG. 8 (f). In addition, the seed crystal layer 107 was metal-bonded to a pre-prepared conductive substrate 321 on which Au 507 was formed. Moreover, as shown in FIG. 8 (g), each of the isolated chips was picked up and adhered by soldering onto a substrate 322 where an electronic circuit had been formed thereon. As a result, the vertical power device (SBD) serving as a semiconductor device was successfully formed.

### Example 4: Vertical Light-emitting Device

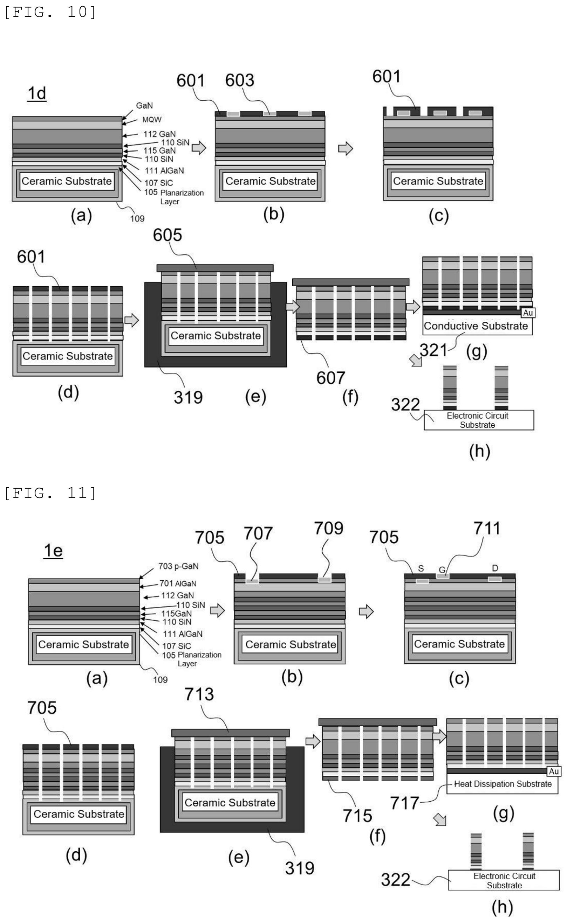

First, through the following procedure, a GaN epitaxial film 112 was grown to produce an epitaxial substrate 1d shown in FIG. 10 (a).

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, 6H-SiC (a resistivity of 20 Ωcm, a thickness of 0.04 µm to 1.0 µm, and an epitaxial growth surface serving as a Si-plane with an off-angle of 0°) was transferred as the seed crystal layer 107 onto the planarization layer 105. Then, as in Example 1, an Al_{0.2}Ga_{0.8}N layer was formed by 0.15 µm as a buffer layer 111 on the seed crystal layer 107. The Al_{0.2}Ga_{0.8}N layer was doped with Si at 1.0×10¹⁹ atoms/cm³.

Next, as in Example 1, a SiN layer 110 was grown in an island shape by 1 nm on the buffer layer 111, and a GaN layer 115 was then epitaxially grown by 3.0 µm. Subsequently, the SiN layer 110 was grown in an island shape to a thickness of 1 nm on the GaN layer 115, and the GaN epitaxial film 112 was further epitaxially grown by 4.0 µm.

Further, 6 pairs of MQWs (multiple quantum wells) (InGaN: 2.3 nm / GaN: 11 nm) were grown as an active layer of a light-emitting diode.

Furthermore, a Mg-doped GaN layer was grown by 200 nm.

Through the above steps, the epitaxial substrate 1d for a vertical light-emitting device was successfully produced.

When dislocation density near a surface of the epitaxial substrate 1d was measured as in Example 1, the measured density was 9.0×10⁵ cm⁻². Consequently, the epitaxial substrate 1d for a vertical device, on which a high-quality GaN epitaxial film 112 was grown, was successfully produced.

Next, this epitaxial substrate 1d for a vertical device was processed through the device processes below to produce the vertical light-emitting device.

To begin with, as shown in FIG. 10 (b), a mask 601 was formed by photolithography on an outermost surface of an epitaxial substrate 1c for a vertical device, and a p-electrode 603 was then formed by sputtering. Subsequently, as shown in FIG. 10 (c), the mask 601 was formed by photolithography to protect the p-electrode 603; in addition, the mask 601 for device isolation was formed.

Next, as shown in FIG. 10 (d), dry etching was performed down to SiO₂ serving as the planarization layer 105. Furthermore, as shown in FIG. 10 (e), a temporary support substrate 605 was attached to the p-electrode 603 side, and this structure was immersed in an HF solution 319 to dissolve the planarization layer 105, thereby separating a device layer portion from a portion below the planarization layer 105.

Next, as shown in FIG. 10 (f), an n-electrode 607 was formed by sputtering on the seed crystal layer 107 exposed on the device layer portion side that has been separated. Furthermore, as shown in FIG. 10 (g), Au was formed by sputtering on a surface of the seed crystal layer 107, and this layer was then metal-bonded to a pre-prepared conductive substrate 321 on which Au was formed. This structure was then subjected to sintering treatment. Moreover, as shown in FIG. 10 (f), each chip was picked up and adhered by soldering onto a substrate 322 where an electronic circuit had been formed thereon. As a result, the vertical light-emitting device as a semiconductor device was successfully formed.

### Example 5: Lateral Power Device

To begin with, through the following procedure, a GaN epitaxial film 112 was grown to produce an epitaxial substrate 1e for a lateral power device shown in FIG. 11 (a).

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, 4H-SiC (a resistivity of 1.0×10⁶ Ωcm or more, a thickness of 0.04 µm to 1.0 µm, and an epitaxial growth surface serving as a Si-plane with an off-angle of 0°) was transferred as the seed crystal layer 107 onto the planarization layer 105. Then, as in Example 1, an Al_{0.2}Ga_{0.8}N layer was formed by 0.15 µm as a buffer layer 111 on the seed crystal layer 107.

Next, as in Example 1, a SiN layer 110 was grown in an island shape to a thickness of 1 nm on the buffer layer 111, and a GaN layer 115 was then epitaxially grown by 3.4 µm. Subsequently, the SiN layer 110 was grown in an island shape by 1 nm on the GaN layer 115, and the GaN epitaxial film 112 was further epitaxially grown thereon to a thickness of 4.0 µm.

On top of the above layers, an Al_{0.25}Ga_{0.75}N layer 701 serving as a barrier layer was epitaxially grown to a thickness of 25 nm, followed by a p-GaN layer 703 doped with Mg to a thickness of 3 nm. Through the above steps, the epitaxial substrate 1e for a lateral power device was successfully produced.

When dislocation density near a surface of the epitaxial substrate 1e was measured as in Example 1, the measured density was 9.0×10⁵ cm⁻². Consequently, the epitaxial substrate 1e for a lateral power device, on which a high-quality GaN epitaxial film 112 was grown, was successfully produced.

Next, this epitaxial substrate 1e for a lateral power device was processed through the device processes below to produce the lateral power device.

To begin with, as shown in FIG. 11 (b), a mask 705 for forming S (source) and D (drain) electrodes was formed by photolithography, and then by dry etching, 4 nm was etched down to the upper portion of an Al_{0.25}GaN layer 701.

Next, an S electrode 707 and a D electrode 709 were formed by sputtering. Moreover, as shown in FIG. 11 (c), the mask 705 for forming a G (gate) electrode was formed by photolithography, and a G electrode 711 was sputtered, and the substrate was subjected to sintering treatment.

Next, the mask 705 for device isolation was formed by photolithography, and, as shown in FIG. 11 (d), dry etching was performed to etch down to the planarization layer 105. Moreover, as shown in FIG. 11 (e), this structure was bonded to a temporary support substrate 713, and then immersed in an HF solution 319 to dissolve SiO₂ serving as the planarization layer 105, thereby separating a device layer portion from a portion below the planarization layer 105.

Next, as shown in FIG. 11 (f), in a state where the device of the device layer portion was supported by the temporary support substrate 713, the exposed seed crystal layer 107 was coated with a thin Au film 715, and was then metal-bonded to a heat dissipation substrate 717 coated with the thin Au film 715.

Moreover, as shown in FIG. 11 (h), each chip was picked up and mounted at a designated position on a substrate 322 on which an electronic circuit was formed. As a result, the lateral power device, as a semiconductor device, was successfully formed.

### Example 6: Lateral Light-emitting Device

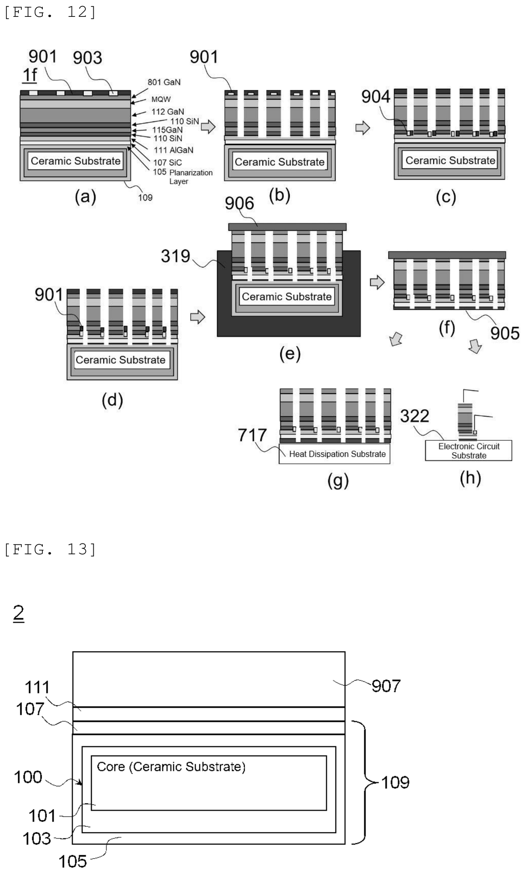

First, through the following procedure, a GaN epitaxial film 112 was grown, thereby producing an epitaxial substrate 1f for a lateral light-emitting device shown in FIG. 12 (a).

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, 6H-SiC (a resistivity of 20 Ωcm, a thickness of 0.04 µm to 1.0 µm, and an epitaxial growth surface serving as a Si-plane with an off-angle of 0°) was transferred as the seed crystal layer 107 onto the planarization layer 105. Then, as in Example 1, an Al_{0.2}Ga_{0.8}N layer was formed by 0.15 µm as a buffer layer 111 on the seed crystal layer 107. The Al_{0.2}Ga_{0.8}N layer was doped with Si at 1.0×10¹⁹ atoms/cm³.

Next, as in Example 1, a SiN layer 110 was grown in an island shape to a thickness of 1 nm on the buffer layer 111, and a GaN layer 115 was then epitaxially grown to a thickness of 3 µm. Subsequently, the SiN layer 110 was grown in an island shape to a thickness of 1 nm on the GaN layer 115, and the GaN epitaxial film 112 was further epitaxially grown to a thickness of 4 µm.

Next, 6 pairs of MQWs (InGaN: 2.3 nm / GaN: 11 nm) serving as an active layer of a light-emitting diode were grown, thereby growing a Mg-doped GaN layer 801 to 200 nm. Through the above steps, the epitaxial substrate 1f for a lateral light-emitting device was produced.

When dislocation density near a surface of the epitaxial substrate 1f was measured as in Example 1, the measured density was 9.0×10⁵ cm⁻². Consequently, the epitaxial substrate 1f for a lateral light-emitting device, on which a high-quality GaN epitaxial film 112 was grown, was successfully produced.

Next, this epitaxial substrate 1f for a lateral light-emitting device was processed through the device processes below to produce the lateral light-emitting device.

To begin with, as shown in FIG. 12 (a), a mask 901 was formed by photolithography, and a p-electrode 903 was formed by sputtering.

Next, as shown in FIG. 12 (b), the mask 901 was formed by photolithography for forming an n-electrode, and dry etching was performed to simultaneously dry-etch an n-electrode formed portion and a device isolation portion down to an upper portion of the buffer layer 111 composed of Al_{0.2}Ga_{0.8}N.

Thereafter, as shown in FIG. 12 (c), the mask 901 was formed by photolithography to form the n-electrode 904, and sintering was performed to form an ohmic electrode. Subsequently, as shown in FIG. 12 (d), the mask 901 was formed by photolithography for the device isolation, and dry etching was performed on the buffer layer 111 (Al_{0.2}Ga_{0.8}N) and the seed crystal layer 107 (SiC) to expose SiO₂ serving as the planarization layer 105.

Next, as shown in FIG. 12 (e), the above structure was bonded to a temporary support substrate 906, and immersed in an HF solution 319 to dissolve SiO₂ serving as the planarization layer 105, thereby separating a device layer portion from a portion below the planarization layer 105. Then, a thin Au film 905 was formed on the seed crystal layer 107 exposed to the device layer portion side (FIG. 12 (f)).

Next, as shown in FIG. 12 (g), the seed crystal layer 107 was metal-bonded to a heat dissipation substrate 717 coated with the thin Au film 905. Moreover, as shown in FIG. 12 (h), each chip was picked up and mounted at a designated position on a substrate 322 on which an electronic circuit was formed. As a result, the lateral light-emitting device serving as a semiconductor device was successfully formed.

### Example 7: Epitaxial Substrate for Vertical Device

An epitaxial substrate was produced in the same way as in Example 1, except that a SiN layer 110 and a GaN layer 115 formed thereon, both formed in Example 1, were not formed. As in Example 1, when dislocation density of the GaN layer 120 was measured, the measured density was 1×10⁶ cm⁻². Although the dislocation density was higher than that in Example 1, a high-quality epitaxial substrate having a dislocation density of 1×10⁶ cm⁻² or less was successfully obtained.

### Comparative Example 1

A GaN epitaxial film 112 was grown through the following procedure, thereby producing an epitaxial substrate 2 as shown in FIG. 13.

To begin with, as in Example 1, a structure was produced, in which a nitride ceramic substrate (AlN) serving as a core 101 was covered with an encapsulating layer 103, and silicon oxide having a thickness of 0.05 µm to 3.0 µm was provided as a planarization layer 105 on at least a side to be bonded to a seed crystal layer 107.

Next, instead of SiC, Si (a resistivity of 20 Ωcm, a thickness of 0.04 µm to 1.0 µm, and an off-angle of 0°) was transferred as the seed crystal layer 107 onto the planarization layer 105. Then, as in Example 1, an Al_{0.2}Ga_{0.8}N layer having a thickness of 0.15 µm was formed as a buffer layer 111 on the seed crystal layer 107.
The Al_{0.2}Ga_{0.8}N layer was doped with Si at 1.0×10¹⁹ atoms/cm³. Then, a GaN layer 907 was epitaxially grown by 7 µm, as in Example 1.

When dislocation density near a surface of the GaN layer 907 was measured as in Example 1, the measured density was 2×10⁸ cm⁻² and higher than those of Examples. Subsequently, a GaN layer 909 was further epitaxially grown by 19 µm using HVPE, and an epitaxial substrate for a vertical device was produced. Further, when the dislocation density near the surface of the GaN layer 907 was measured as in Example 1, the measured density was 9×10⁶ cm⁻², and higher than those of Examples.

The present description includes the following embodiments.
[1]: A method for producing a GaN epitaxial film, the method comprising the steps of:
   providing a support substrate having a diameter of 150 mm or more and a thickness of less than 1 mm, in which the support substrate comprises a core composed of nitride ceramic enclosed by an encapsulating layer;
   producing a substrate in which a planarization layer and a seed crystal layer composed of SiC single crystal are sequentially laminated on the support substrate to obtain a substrate for epitaxial growth; and
   epitaxially growing a GaN epitaxial film having a thickness of 7 µm or more on the substrate for epitaxial growth,
   by which the GaN epitaxial film having a dislocation density of 1.0×10⁶ / cm² or less is produced.
[2]: The method for producing a GaN epitaxial film of the above [1], wherein
   in the step of epitaxially growing,
   a forming step for forming a SiN layer in an island shape and an ELO step for growing a GaN layer using the SiN layer as a mask are performed, and a growth step is subsequently performed to grow the GaN epitaxial film on the uppermost SiN layer or the uppermost GaN layer.
[3]: The method for producing a GaN epitaxial film of the above [2], wherein
   in the step of epitaxially growing,
   the forming step and the ELO step are alternately performed.
[4]: The method for producing a GaN epitaxial film of any of the above [1] to [3], wherein
   the SiC single crystal has an off-angle of 0° to 4°.
[5]: A method for producing a semiconductor device, the method comprising:
   forming a device on the GaN epitaxial film produced by the method for producing a GaN epitaxial film of any of the above [1] to [4]; and
   subsequently, etching the planarization layer to separate the device from the support substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a GaN epitaxial film, the method comprising the steps of:
providing a support substrate having a diameter of 150 mm or more and a thickness of less than 1 mm, in which the support substrate comprises a core composed of nitride ceramic enclosed by an encapsulating layer;
producing a substrate in which a planarization layer and a seed crystal layer composed of SiC single crystal are sequentially laminated on the support substrate to obtain a substrate for epitaxial growth; and
epitaxially growing a GaN epitaxial film having a thickness of 7 µm or more on the substrate for epitaxial growth,
by which the GaN epitaxial film having a dislocation density of 1.0×10⁶ / cm² or less is produced.

2. The method for producing a GaN epitaxial film according to claim 1, wherein
in the step of epitaxially growing,
a forming step for forming a SiN layer in an island shape and an ELO step for growing a GaN layer using the SiN layer as a mask are performed, and a growth step is subsequently performed to grow the GaN epitaxial film on the uppermost SiN layer or the uppermost GaN layer.

3. The method for producing a GaN epitaxial film according to claim 2, wherein
in the step of epitaxially growing,
the forming step and the ELO step are alternately performed.

4. The method for producing a GaN epitaxial film according to claim 1, wherein
the SiC single crystal has an off-angle of 0° to 4°.

5. A method for producing a semiconductor device, the method comprising:
forming a device on the GaN epitaxial film produced by the method for producing a GaN epitaxial film according to any one of claims 1 to 4; and
subsequently, etching the planarization layer to separate the device from the support substrate.
